# EUROPÄISCHE PATENTANMELDUNG

(11) **EP 4 362 080 A1**
(43) Veröffentlichungstag der Anmeldung: **01.05.2024**
(21) Anmeldenummer: 22204466.1
(22) Anmeldetag: 28.10.2022
(51) Int. Cl.: H01L 23/40, H01L 23/498, H01L 23/48

(54) **SCHALTUNGSANORDNUNG MIT KONTAKTSTIFTEN**

(71) Anmelder: Siemens Aktiengesellschaft, 80333 München (DE)
(72) Erfinder: Strogies, Jörg, 14163 Berlin (DE); Heimann, Matthias, 14469 Potsdam (DE); Müller, Bernd, 16259 Falkenberg (DE)
(74) Vertreter: Siemens Patent Attorneys

(57) **Zusammenfassung**

Es wird eine Schaltungsanordnung mit einer Halbleiterbaugruppe mit einer Mehrzahl von parallel zueinander angeordneten Kontaktstiften und einem Schaltungsträger mit einer Mehrzahl von den Kontaktstiften zugeordneten innenmetallisierten Kontaktöffnungen angegeben, wobei die Kontaktstifte in die Kontaktöffnungen eingesteckt sind und die Kontaktöffnungen an ihrer Innenseite ein Material aufweisen, dessen Schmelzpunkt bei einer Temperatur von höchstens 150 °C liegt.

## Beschreibung

Die Erfindung betrifft eine Schaltungsanordnung mit einem oder mehreren Halbleiterbaugruppen, wobei die Halbleiterbaugruppen Kontaktstifte aufweisen, die in Kontaktöffnungen eines Schaltungsträgers eingesteckt werden.

Leistungselektronische Halbleiterbaugruppen müssen infolge immer höherer Verlustleistungsdichten möglichst optimal gekühlt werden. Häufig werden entsprechend der Schaltungstopologien und Leistungsanforderungen mehrere Baugruppen auf einem gemeinsamen Schaltungsträger (Motherboard) angeordnet. Diese Aufbauhierarchie weist Vorteile auf in Bezug auf Modularität bei gleichzeitig hoher Miniaturisierung und wird daher häufig verwendet.

Die Wärmeabfuhr wird hierbei hauptsächlich an der dem Motherboard gegenüberliegenden Oberfläche der Halbleiterbaugruppen hin zu einem Kühlkörper gewährleistet. Dabei handelt es sich typischerweise um einen gemeinsamen Kühlkörper für mehrere Halbleiterbaugruppen einer Schaltungsanordnung. Die Ausrichtung mehrerer Halbleiterbaugruppen zu einer gemeinsamen Kühlkörperoberfläche stellt dabei einen Kompromiss dar, da beispielsweise die Dicken der Halbleiterbaugruppen voneinander verschieden sind und deren jeweilige Flächennormalen sich durch Abweichungen in den Fügeprozessen von Baustein zu Baustein unterscheiden.

Die Annäherung der kritischen Oberflächen stellt aufgrund dieser Abweichungen eine besondere Herausforderung dar. Der verbleibende Spalt zum Kühlköper wird typischerweise durch Wärmeleitpasten oder Pads geschlossen, wobei diese aufgrund ihrer vergleichsweise niedrigen Wärmeleitfähigkeit im Vergleich zu Metallen oder Keramiken so dünn wie möglich gehalten werden müssen.

Die notwendigen thermisch leitenden Kontakte bedingen zudem einen Anpressdruck der Halbleiterbaugruppen in Richtung Kühlkörper, wobei dieser durch die mechanischen Beeinflussungen und dem damit verbundenem Schädigungspotential hinsichtlich der Fügepartner begrenzt wird. Als Grundsatz kann hierbei genannt werden: Je größer der Anpressdruck, desto geringer ist der thermische Widerstand und umso größer ist das Vermögen, die kritischen Interfaces für den Wärmeübergang anzunähern, aber desto größer auch mögliche Schädigungen der Fügepartner.

Nachteilig ist also, dass die Dicke von Wärmeleitpaste oder Pads groß genug sein muss, um die kaum zu vermeidenden Dickenschwankungen und Verkippungen der Halbleiterbaugruppen jederzeit ausgleichen zu können und somit diese Dicke wesentlich größer gewählt werden muss, als es bei Halbleiterbaugruppen gleicher Dicke und exakter Ausrichtung der Fall wäre, was die thermischen Eigenschaften verschlechtert.

Es ist Aufgabe der Erfindung, eine Schaltungsanordnung der eingangs genannten Art anzugeben, bei der die genannten Nachteile verringert werden.

Diese Aufgabe wird durch eine Schaltungsanordnung mit den in Anspruch 1 angegebenen Merkmalen gelöst.

Die erfindungsgemäße Schaltungsanordnung umfasst eine Halbleiterbaugruppe mit einer Mehrzahl von parallel zueinander angeordneten Kontaktstiften. Weiterhin umfasst die Schaltungsanordnung einen Schaltungsträger mit einer Mehrzahl von den Kontaktstiften zugeordneten innenmetallisierten Kontaktöffnungen, wobei die Kontaktstifte in die Kontaktöffnungen eingesteckt sind.

Ferner weist die Schaltungsanordnung ein Deckelelement auf, das auf der von dem Schaltungsträger abgewandten Seite der Halbleiterbaugruppe angeordnet ist, sowie Mittel zum Erzeugen einer ersten Kraft, die den Schaltungsträger und das Deckelelement zueinander drückt.

Dabei weisen die Kontaktöffnungen an ihrer Innenseite ein Material auf, das einen Schmelzpunkt von höchstens 150 °C aufweist. Zwischen der Halbleiterbaugruppe und der Leiterplatte sind mehrere Federelemente angeordnet, die zweite Kräfte zwischen Leiterplatte und Halbleiterbaugruppe bewirken, die die Halbleiterbaugruppe an das Deckelelement andrücken.

Die dem Deckelelement zugewandte Seite der Halbleiterbaugruppe wird zur Vereinfachung als Oberseite bezeichnet. Die entgegengesetzte Seite wird als Unterseite bezeichnet.

Durch die Erfindung werden Unterschiede in der Oberfläche, Dicke und Ausrichtung zwischen nebeneinander angeordneten Bauelementen in der Schaltungsanordnung korrigiert und somit eine optimale Ausrichtung einer jeweiligen Oberfläche eines Bauelements zum Deckelelement erreicht. Die Unterschiede können durch unterschiedliche Dicken der Bauelemente bewirkt werden, wobei diese beabsichtigt sein können oder auch unbeabsichtigt, also durch Herstellungsschwankungen. Weiterhin können die Unterschiede durch thermische Spannungen bewirkt werden.

Dabei kommt zum Tragen, dass das Material einen so niedrigen Schmelzpunkt hat, dass es bei Betriebstemperatur des elektronischen Aufbaus oder zumindest bei einer darüber hinaus leicht erhöhten Temperatur flüssig ist. Die Kontaktöffnungen und die Kontaktstifte sind zweckmäßig so gestaltet, dass durch das flüssige Material eine freie Bewegung der Kontaktstifte in den Kontaktöffnungen in der Erstreckungsrichtung der Öffnungen ermöglicht ist. Sind beispielsweise zwei verschieden dicke Halbleiterbaugruppen nebeneinander angeordnet, dann können die zweiten Kräfte, die durch die Federelemente bewirkt werden, die dünnere Halbleiterbaugruppe anheben und somit den deren Abstand zum Deckelelement minimieren.

Dadurch wird bewirkt, dass die Halbleiterbaugruppen trotz auftretender Unterschiede in Dicke und Ausrichtung optimal am Deckelelement anliegen und somit die Menge an Wärmeleitpaste oder Pads zwischen den genannten Elementen minimiert werden kann. Dadurch wird der thermische Kontakt zwischen der Halbleiterbaugruppe und dem Deckelelement verbessert.

Mit anderen Worten wird eine Kompensation der Höhentoleranzen und eine optimierte Nivellierung bezüglich einer Basisebene durch eine permanente Anpassung durch Einzug und Auszug der gleitend gelagerten Kontaktstifte vorgenommen. Dabei bleibt der jeweilige elektrische Kontakt zwischen Kontaktstift und Kontaktöffnung erhalten. Die Notwendigkeit eines Kompromisses als Ausgleich zwischen den verschiedenen Oberseiten der Halbleiterbaugruppen bezüglich der Ebene des Kühlkörpers entfällt, da jede einzelne Halbleiterbaugruppen bezüglich ihrer Lage angepasst wird. Dies funktioniert auch fortwährend unter Betriebsbedingungen, da die gleitende Lagerung der Pins auch nach der Montage der Anordnung bestehen bleibt, sobald die Schmelztemperatur des Materials erreicht ist.

Bei der Halbleiterbaugruppe handelt es sich zweckmäßig um wenigstens ein Halbleiterbauelement mit Kontaktstiften oder aber um einen Aufbau, der ein solches Halbleiterbauelement, beispielsweise eine Diode, einen IGBT oder MOSFET umfasst. Die Halbleiterbaugruppe kann auch mehrere Halbleiterbauelemente umfassen. Die Oberseite ist dabei zweckmäßig planar, um eine gute thermische Anbindung an das Deckelelement zu ermöglichen.

Die Kontaktstifte (Pins) sind zweckmäßig metallisch und sind senkrecht zur Ebene des Schaltungsträgers ausgerichtet. Sie sind daher auch bevorzugt alle parallel.

Vorteilhafte Ausgestaltungen der erfindungsgemäßen Schaltungsanordnung gehen aus den abhängigen Ansprüchen hervor. Dabei kann die Ausführungsform der unabhängigen Ansprüche mit den Merkmalen eines der Unteransprüche oder vorzugsweise auch mit denen aus mehreren Unteransprüchen kombiniert werden. Demgemäß können noch zusätzlich folgende Merkmale vorgesehen werden:
Die Federelemente können so angeordnet sein, dass die zweiten Kräfte eine Verkippung der Halbleiterbaugruppe bewirken können. Eine Verkippung wird dadurch erreicht, dass die Federelemente eine voneinander verschiedene Dehnung erfahren und dadurch die Halbleiterbaugruppe an ihren Rändern um unterschiedliche Längen angehoben oder abgesenkt wird.

Hierdurch wird vorteilhaft bewirkt, dass auch dann ein guter Kontakt zwischen der Oberseite der Halbleiterbaugruppe und der Unterseite des Deckelelements gewährleistet bleibt, wenn der Schaltungsträger und das Deckelelement gegeneinander verkippt oder verkrümmt sind, beispielsweise durch thermische Spannungen oder anderweitige Verformungen im Bereich der Halbleiterbaugruppe.

Die Federelemente können am Rand der Halbleiterbaugruppe angeordnet sein. Möglichst weit außen an der Halbleiterbaugruppe angreifende Federelemente haben den Vorteil, dass sie am besten und genauesten eine Ausrichtung der Oberseite der Halbleiterbaugruppe auf die Unterseite des Deckelelements bewirken können. Hierdurch wird der verbleibende Abstand zwischen den beiden Elementen minimiert und somit der thermische und/oder elektrische Kontakt optimiert.

Die Schaltungsanordnung kann eine Paste zur Wärmeleitung und/oder elektrischen Leitung zwischen dem Deckelelement und der dem Deckelelement zugewandten Seite der Halbleiterbaugruppe umfassen. Die Paste bewirkt in bekannter Weise eine thermische Verbindung und/oder elektrische Verbindung zwischen dem Halbleiterbauelement und dem Deckelelement, bei der die verbleibenden Lücken zwischen den Oberflächen ausgefüllt werden und somit der Kontakt deutlich besser ist als ohne die Paste. Gegenüber bekannten Schaltungsanordnungen ist die Menge an Paste, die notwendig ist, um den Kontakt zu gewährleisten, niedriger. Da Pasten stets schlechtere Eigenschaften bzgl. der Wärmeleitung oder elektrischen Leitung aufweisen als die Feststoffe wie Kupfer oder Aluminium, ist eine geringere Dicke der Paste vorteilhaft für die Eigenschaften der Schaltungsanordnung.

Das Deckelelement kann ein Kühlkörper sein. Der Kühlkörper kann beispielsweise aus Aluminium oder Kupfer bestehen. Alternativ kann das Deckelelement ein zweiter Schaltungsträger sein. Die Halbleiterbaugruppe kann in diesem Fall auf ihrer Oberseite ein oder mehrere Lastanschlüsse aufweisen. Das Deckelelement kann auf seiner Unterseite dazu passende Metallisierungen aufweisen, die eine Kontaktierung der Lastanschlüsse bewirken.

Das Material kann bei Raumtemperatur flüssig sein. In diesem Fall ist eine Bewegung der Kontaktstifte in den Kontaktöffnungen auch bei Raumtemperatur möglich. Dadurch werden auch solche Verformungen innerhalb der Schaltungsanordnung ausgeglichen, die bei Raumtemperatur auftreten. Solche Verformungen entstehen beispielsweise dadurch, dass Herstellungsschritte für Teile der Schaltungsanordnung deutlich oberhalb der Raumtemperatur erfolgen. Durch die Mittel zum Ausüben der ersten Kraft wird der Aufbau aber sicher zusammengehalten.

Das Material kann alternativ bei Raumtemperatur fest sein. Ein solches Material hat den Vorteil, dass sich die Halbleiterbaugruppe bei Raumtemperatur, also außerhalb von Betriebszeiten, nicht einfach aus der Verankerung in den Kontaktöffnungen lösen kann. Gleichzeitig aber erlaubt das Material bei Betriebstemperatur eine Beweglichkeit der Kontaktstifte bei Betriebstemperatur. Auch ist vorteilhaft ein Austreten des Materials aus den Kontaktöffnungen beim Transport erschwert.

Das Material kann beispielsweise einen Gallium-Anteil aufweisen. Gallium bietet mit seinem Schmelzpunkt von ca. 29 °C einen guten Ausgangspunkt für Materialien, die bei Betriebstemperatur flüssig sind und zugleich eine gute elektrische Leitfähigkeit aufweisen. Auch die hohe Oberflächenspannung ist vorteilhaft, um das flüssige Material in den Kontaktöffnungen zu halten.

Das Material kann beispielsweise eine eutektische Legierung mit Gallium, Indium und Zinn sein. Eine solche Legierung ist bekannt für einen Schmelzpunkt von im Bereich von -10 °C bis -20 °C und weist ansonsten passende Eigenschaften bezüglich der elektrischen Leitfähigkeit und Oberflächenspannung auf. Ist das Material auch bei Raumtemperatur flüssig, wird dadurch vorteilhaft vermieden, dass thermische Spannungen nach einem Betrieb bei erhöhter Temperatur und Abkühlung auftreten und nicht durch eine Bewegung des Halbleiterbauelements ausgeglichen werden können. Vielmehr bleibt das Halbleiterbauelement stets beweglich, sodass thermische Spannungen durch Erwärmung und Abkühlung zumindest in diesem Bereich nicht auftreten.

In bestimmten Ausgestaltungen liegt die Schmelztemperatur des Materials unterhalb von 120 °C oder 100 °C. Beispielsweise kann das Material auch ein niedrigschmelzendes Lot sein. In bestimmten Ausgestaltungen der Erfindung liegt die Schmelztemperatur oberhalb der typischen Betriebstemperatur. In diesem Fall bringen lokale Überhöhungen der Temperatur, die beispielsweise durch eine momentan erhöhte Belastung eines der Halbleiterbauelement auftritt, das Material zum Schmelzen und erlauben damit die verbesserte Ausrichtung von Halbleiterbaugruppe und Deckelelement.

Bei den Federelementen kann es sich um Blattfedern, Spiralfedern oder Stücke eines elastischen Materials wie beispielsweise einem Elastomer oder Silikon handeln. Die bezeichneten Stücke sind bevorzugt quaderförmig. Sie können beispielsweise mit der Oberfläche des Schaltungsträgers und/oder der Halbleiterbaugruppe verklebt sein.

Im Folgenden wird die Erfindung anhand der in den Figuren dargestellten Ausführungsbeispiele näher beschrieben und erläutert. Es zeigen:
- Figur 1: eine erste schematische Schnittdarstellung eines ersten Ausführungsbeispiels einer Schaltungsanordnung in einer Betriebssituation,
- Figur 2: Kontaktstifte und Kontaktöffnungen in der Schaltungsanordnung in verschiedenen Betriebssituationen.

Einander entsprechende Teile sind in den Figuren mit denselben Bezugszeichen versehen.

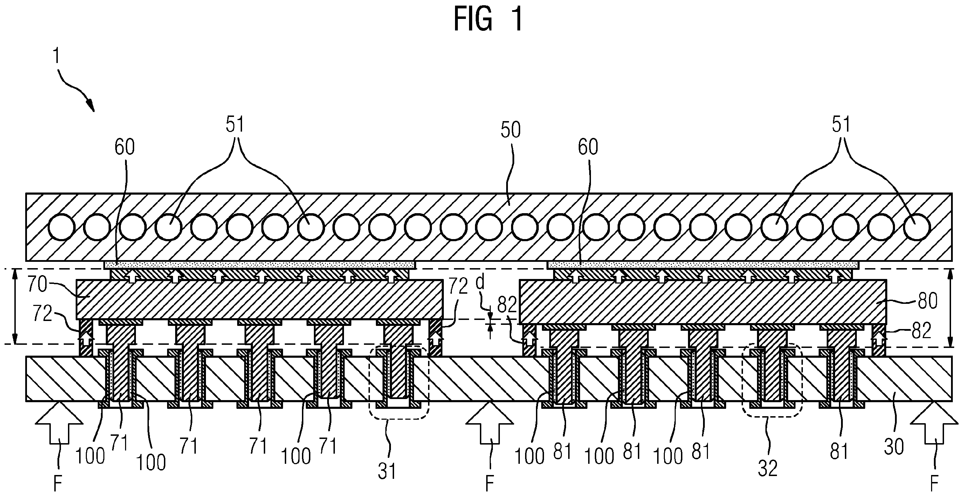

Figur 1 zeigt eine schematische Schnittdarstellung eines Ausführungsbeispiels für die Erfindung. Die Schaltungsanordnung 1 umfasst einen Schaltungsträger 30 und einen Kühlkörper 50. Beispielsweise ist der Schaltungsträger 30 ein DCB-Substrat (DCB: Abkürzung für Direct Copper Bonded) oder ein AMB-Substrat (AMB: Abkürzung für Active Metal Brazing).

Der Kühlkörper 50 ist in diesem Beispiel ein Kupferkühlkörper. Den Kühlkörper 50 durchdringend sind Fluidleitungen 51 angeordnet, durch die beispielsweise Wasser zum Wärmeabtransport geleitet werden kann. In alternativen Ausgestaltungen kann der Kühlkörper 50 auch aus Aluminium oder einem anderen Material bestehen. Der Kühlkörper 50 kann auch eine elektrisch isolierende Schicht auf seiner Unterseite umfassen.

Weiterhin umfasst die Schaltungsanordnung 1 eine erste und zweite Halbleiterbaugruppe 70, 80. Die Halbleiterbaugruppen 70, 80 sind nebeneinander zwischen dem Schaltungsträger 30 und dem Kühlkörper 50 angeordnet. Die Unterseite des Kühlkörpers 50 ist die den Halbleiterbauelementen 70, 80 zugewandte Seite.

Die Halbleiterbaugruppen 70, 80 sind im Wesentlichen planare Baugruppen, die jeweils ein oder mehrere Halbleiterbauelemente umfassen. Die Halbleiterbauelemente können beispielsweise Bipolartransistoren oder Bipolartransistoren mit isolierter Gate-Elektrode (engl. Insulated-Gate Bipolar Transistor, abgekürzt IGBT) sein. Alternativ kann es sich auch um Feldeffekttransistoren, insbesondere Metall-Oxid-Halbleiter-Feldeffekttransistoren (engl. Metal-Oxide-Semiconductor Field-Effect Transistor, abgekürzt MOSFET) handeln. Bei anderen Ausführungsbeispielen können die Halbleiterbauelemente auch Thyristoren oder Dioden sein. Dabei können die Halbleiterbauelemente voneinander verschiedene Typen sein.

Die Halbleiterbauelemente sind in den Halbleiterbaugruppen 70, 80 zu einem Aufbau zusammengesetzt, der eine im Wesentlichen gerade Ober- und Unterseite aufweist. An der Oberseite, die dem Kühlkörper 50 zugewandt ist, umfassen die Halbleiterbaugruppen 70, 80 eine wärmeleitende Schicht 75, 85, beispielsweise eine Kupferschicht. Diese wärmeleitende Schicht 75, 85 dient der thermischen Anbindung an den Kühlkörper 50. Die wärmeleitende Schicht ist in diesem Beispiel elektrisch leitend, muss es aber nicht sein.

Auf ihrer Unterseite weisen die Halbleiterbaugruppen 70, 80 jeweils eine Mehrzahl von metallischen Kontaktstiften (Pins) 31, 32 auf. Diese dienen der elektrischen Kontaktierung für Steuer- und Lastanschlüsse der Halbleiterbaugruppen 70, 80 und können teilweise elektrisch parallelgeschaltet sein. Die Kontaktstifte 71, 81 verlaufen dabei zumindest zu ihrem Ende hin parallel zueinander in einer Richtung senkrecht zur Ebene des Schaltungsträgers 30 und zu diesem hingewandt.

Der Schaltungsträger 30 weist eine Mehrzahl von Kontaktöffnungen 31, 32 (auch als Vias bezeichnet) auf. Die Kontaktöffnungen 31, 32 sind dabei den Kontaktstiften 71, 81 zugeordnet und so angeordnet, dass die Halbleiterbaugruppen 70, 80 mit den Kontaktstiften 71, 81 in die Kontaktöffnungen 31, 32 eingesteckt werden können. In der Schaltungsanordnung 1 sind die Halbleiterbaugruppen 70, 80 eingesteckt. Die Kontaktöffnungen 31, 32 sind als den Schaltungsträger 30 durchdringende Bohrungen ausgeführt. Sie weisen an ihrer Innenoberfläche eine Metallisierung auf. Diese Metallisierung erstreckt sich um eine Strecke im Millimeter-Bereich auf den Außenflächen des Schaltungsträgers 30 kreisförmig um die Bohrung herum als Kragen und dient der elektrischen Kontaktierung zu anderen Schaltungselementen auf dem Schaltungsträger 30 mittels vom Kragen ausgehenden Leiterbahnen auf einer jeweiligen Oberfläche des Schaltungsträgers 30.

Figur 1 zeigt im Schnittbild nur fünf Kontaktstifte 71, 81 und Kontaktöffnungen 31, 32. Die Halbleiterbaugruppen 70, 80 weisen typischerweise mehr Kontaktstifte 71, 81 auf, wobei diese den Rand der jeweiligen Halbleiterbaugruppe 70, 80 umlaufend angeordnet sind und somit ein Rechteck oder Quadrat bilden. Entsprechendes gilt für die Kontaktöffnungen 31, 32.

Im Gegensatz zu bekannten Schaltungsträgern der beschriebenen Art umfassen die Kontaktöffnungen 31, 32 ein elektrisch leitfähiges und bei der als Nennwert festgelegten Betriebstemperatur der Schaltungsanordnung 1 flüssiges Material 100. Bei dem Nennwert für die Betriebstemperatur kann es sich beispielsweise um 40 °C oder 80 °C handeln. Bei Raumtemperatur (25 °C) kann das Material 100 flüssig oder fest sein, sofern die Betriebstemperatur nicht die Raumtemperatur ist. Ein Beispiel für ein solches Material 100 ist ein Eutektikum, das Gallium, Indium und Zinn umfasst. Ein solches Material 100 ist bei 0 °C und darüber, also bei jeder typischen Betriebstemperatur, aber auch bei Raumtemperatur flüssig.

In anderen Ausgestaltungen kann das Material 100 beispielsweise Gallium sein oder eine andere Mischung, die beispielsweise Gallium umfassen kann. Gallium selbst hat einen Schmelzpunkt von ca. 30 °C und ist daher bei Raumtemperatur gerade noch fest, aber bei realistischen Betriebstemperaturen flüssig.

Die Kontaktstifte 71, 81 und die Kontaktöffnungen 31, 32 sind so gestaltet, dass im eingesteckten Zustand ein geringes Spiel zwischen den Oberflächen von weniger als 0,1 mm besteht. Kapillarkräfte bewirken, dass das Material T1000 im Zwischenraum zwischen einem Kontaktstift 71, 81 und der Innenwandung der jeweiligen Kontaktöffnung 31, 32 verbleibt und beide Oberflächen benetzt. Dadurch ist ein guter elektrischer Kontakt zwischen den Kontaktstiften 31, 32 und der Metallisierung der Bohrung gewährleistet. Weiterhin ist so eine leichte laterale Bewegung und/oder Verkippung eines Kontaktstifts 71, 81 innerhalb der jeweiligen Kontaktöffnung 31, 32 ermöglicht. Besonders vorteilhaft ist, dass diese Konfiguration eine axiale Bewegung der Kontaktstifte 71, 81 erlaubt, wobei axial die Bohrungsrichtung der Kontaktöffnungen 31, 32 bezeichnet. Die Kontaktstifte 71, 81 sind also nicht wie in bekannten Ausgestaltungen fest, beispielsweise mittels eines Lötmaterials, in den Kontaktöffnungen 31, 32 verankert, sondern vielmehr verhältnismäßig frei beweglich.

Um ein zu weites Herausbewegen der Kontaktstifte 71, 81 oder gar ein Herausfallen zu verhindern, sind daher Mittel vorhanden, um einen maximalen Abstand des Schaltungsträgers 30 von dem Kühlkörper 50 festzulegen oder eine Kraftwirkung zwischen diesen Elementen zu erzeugen, die sie aneinanderdrückt. Beispielsweise kann die Schaltungsanordnung 1 in einem Gehäuse angeordnet sein, das einen maximalen Abstand erzwingt oder es sind passende Verschraubungen, beispielsweise mit Abstandshülsen, vorhanden.

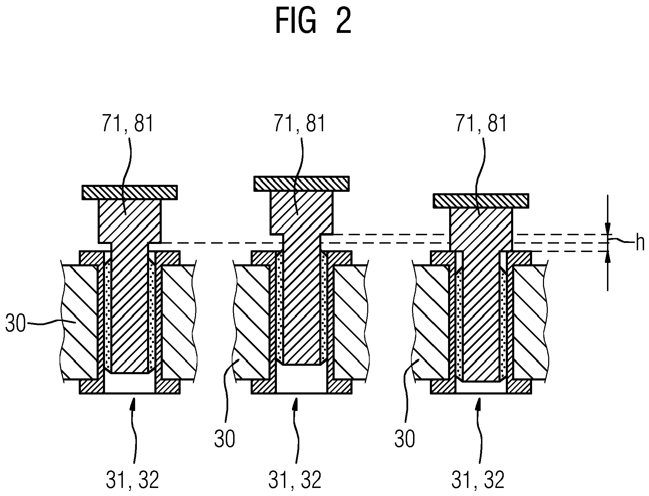

Durch diese Mittel wird also der weiteste Weg festgelegt, um den die Kontaktstifte 71, 81 aus den Kontaktöffnungen 31, 32 im verbauten Zustand herausgezogen werden können. Dieser Weg ist zweckmäßig klein im Vergleich zur Dicke des Schaltungsträgers 30, um in jedem Betriebszustand einen ausreichenden elektrischen Kontakt zu gewährleisten. Eine Situation, in der ein Kontaktstift 71, 81 den weitestmöglichen Weg herausgezogen ist aus der Kontaktöffnung 31, 32, ist in Figur 2 beim mittleren gezeigten Kontaktstift 71, 81 dargestellt.

Ein weiteres Durchdringen der Kontaktöffnung 31, 32 durch einen Kontaktstift 71, 81 wird durch einen Kragen des Kontaktstifts 71, 81, also eine Verdickung, deren Durchmesser größer ist als derjenige der Kontaktöffnung 31, 32, verhindert. Die Situation, in der ein Kontaktstift 71, 81 weitestmöglich in die Kontaktöffnung 31, 32, eingeschoben ist, ist in der Figur 2 rechts dargestellt.

Figur 2 zeigt weiterhin auf der linken Seite einen Kontaktstift 71, 81 in einer mittleren Einschub-Tiefe. Zwischen der maximalen Einschub-Tiefe und der minimalen Einschub-Tiefe ergibt sich ein maximales Ausgleichsvermögen h eines Kontaktstifts 71, 81. Das maximale Ausgleichsvermögen h erstreckt sich in Richtung der Flächennormalen des Schaltungsträgers 30.

Um dieses Ausgleichsvermögen h zu nutzen, umfasst die Schaltungsanordnung im Randbereich der Halbleiterbaugruppen 70, 80 eine Mehrzahl von Federelementen 72, 82. Figur 1 zeigt nur jeweils zwei solcher Federelemente 72, 82, es können aber beispielsweise acht Stück oder eine andere Zahl von Federelementen 72, 82 für jede der Halbleiterbaugruppen 70, 80 vorhanden sein. Sie sind bevorzugt gleichmäßig über den Rand der jeweiligen Halbleiterbaugruppe 70, 80 verteilt, wobei sie zwischen dem Halbleiterbauelement 72, 82 und dem Schaltungsträger 30 angeordnet sind. Die Federelemente 72, 82 sind dabei so gestaltet, dass sie das jeweilige Halbleiterbauelement 72, 82 vom Schaltungsträger 30 wegdrücken und somit für eine Andruckkraft an den Kühlkörper 50 sorgen. Sie erlauben dabei die Bewegung der Halbleiterbaugruppen 70, 80 derart weit, dass das maximale Ausgleichsvermögen h verwendet werden kann.

Bei den Federelementen 72, 82 handelt es sich in diesem Ausführungsbeispiel um quaderförmige Blöcke aus einem Elastomer. Sie sind außerhalb der Reihen aus Kontaktstiften 71, 81 zwischen dem Schaltungsträger 30 und dem über die Kontaktstifte 71, 82 hinausragenden Rand der jeweiligen Halbleiterbaugruppe 70, 80 eingeklemmt und üben so eine Kraft auf die Halbleiterbaugruppe 70, 80 aus, die dahingehend wirkt, dass die Kontaktstifte 71, 81 aus den Kontaktöffnungen 31, 32 herausgezogen werden. Dieser Kraft wirken die Mittel entgegen, die den weitesten Abstand zwischen dem Kühlkörper 50 und dem Schaltungsträger 30 festlegen. Je nach individueller Lage und Dicke der Halbleiterbaugruppe werden dadurch die Kontaktstifte 71, 81 mehr oder weniger weit aus den Kontaktöffnungen 31, 32 herausgezogen im Rahmen des maximalen Ausgleichsvermögens h.

In dem Beispiel gemäß Figur 1 ist die zweite Halbleiterbaugruppe 80 etwas dicker als die erste Halbleiterbaugruppe 70. Besonders, wenn dieser Dickenunterschied herstellungsbedingt ist und nicht vorhersehbar ist, ist ein baulicher Ausgleich schwierig und eine ausreichende Menge an Wärmeleitpaste 60 muss zwischen den Halbleiterbaugruppen 70, 80 und dem Kühlkörper 50 vorhanden sein, um die möglichen Dickenunterschiede auszugleichen. Dasselbe gilt für baulich bedingte oder durch thermische Spannungen verursachte Verkippungen. Wie in Figur 1 dargestellt, sorgen die Federelemente 72, 82 dafür, dass der hier vorhandene Dickenunterschied d zwischen den Halbleiterbaugruppen 70, 80 ausgeglichen wird. Dabei wird die Tatsache ausgenutzt, dass die Kontaktstifte 71, 81 in den Kontaktöffnungen 31, 32 beweglich sind und somit die erste Halbleiterbaugruppe 70 gegenüber der zweiten Halbleiterbaugruppe 80 etwas angehoben werden kann. Dies ist in Figur 1 erkennbar daran, dass die Kontaktstifte 72 der zweiten Halbleiterbaugruppe 80 weiter in die Kontaktöffnungen 32 eingeschoben sind.

Dadurch, dass die Federelemente 72, 82 unabhängig voneinander sind, kann jede der Halbleiterbaugruppen 70, 80 auch verkippt werden im Rahmen das Ausgleichsvermögens h. Dabei werden die Kontaktstifte 71, 81 einer der Halbleiterbaugruppen 70, 80 unterschiedlich weit aus den Kontaktöffnungen 31, 32 herausgedrückt, so dass die betreffende Halbleiterbaugruppe 70, 80 gegenüber dem Schaltungsträger 30 schräg gestellt ist. Damit kann auch eine Verbiegung oder Verwindung von Schaltungsträger 30 und/oder Kühlkörper 50 ausgeglichen werden. Diese können beispielsweise aufgrund von thermischen Spannungen auftreten, die durch unterschiedliche Herstellungstemperatur, Lagerungstemperatur und Betriebstemperatur bewirkt werden.

In anderen Ausführungsformen handelt es sich bei dem Material 100 um ein niedrigschmelzendes Lot mit einer Schmelztemperatur von beispielsweise 100 °C oder 120 °C und die Betriebstemperatur beträgt normalerweise 80 °C. Bei einer solchen Ausführungsform ist das Material 100 bei der Betriebstemperatur noch nicht flüssig, aber bei einer schon leicht erhöhten Temperatur. Dadurch wird ein Ausgleich durch eine Verschiebung der Kontaktstifte 71, 81 dann ermöglicht, wenn eine überhöhte Temperatur auftritt und das Material 100 verflüssigt. Dadurch agiert das Material als Schutzvorrichtung, die bei überhöhten Temperaturen eine verbesserte Anbindung der Halbleiterbaugruppe 70, 80 an den Kühlkörper 50 erlaubt, um den Ursachen einer momentan überhöhten Temperatur entgegenzuwirken.

### Bezugszeichen

- 1: Schaltungsanordnung
- 30: Schaltungsträger
- 31, 32: Kontaktöffnungen
- 50: Kühlkörper
- 51: Fluidkanal
- 60: Wärmeleitpaste
- 70, 80: Halbleiterbaugruppe
- 71, 81: Kontaktstifte
- 72, 82: Federelemente
- 100: Material
- h: maximales Ausgleichsvermögen
- d: Dickenunterschied

## Patentansprüche

1. Schaltungsanordnung (1) mit
- einer Halbleiterbaugruppe (70, 80) mit einer Mehrzahl von parallel zueinander angeordneten Kontaktstiften (71, 81),
- einem Schaltungsträger (30) mit einer Mehrzahl von den Kontaktstiften (71, 81) zugeordneten innenmetallisierten Kontaktöffnungen (31, 32), wobei die Kontaktstifte (71, 81) in die Kontaktöffnungen (31, 32) eingesteckt sind,
- einem Deckelelement (50), das auf der von dem Schaltungsträger (30) abgewandten Seite der Halbleiterbaugruppe (70, 80) angeordnet ist,
- Mittel zum Erzeugen einer ersten Kraft, die den Schaltungsträger (30) und das Deckelelement (50) zueinander drückt, wobei
- die Kontaktöffnungen (31, 32) an ihrer Innenseite ein Material (100) aufweisen, das einen Schmelzpunkt von höchstens 150 °C aufweist,
- zwischen der Halbleiterbaugruppe (70, 80) und dem Schaltungsträger (30) mehrere Federelemente (72, 82) angeordnet sind, die zweite Kräfte zwischen Schaltungsträger (30) und Halbleiterbaugruppe (70, 80) bewirken, die die Halbleiterbaugruppe (70, 80) an das Deckelelement (50) andrücken.

2. Schaltungsanordnung (1) nach Anspruch 1, bei der die Federelemente (72, 82) so angeordnet sind, dass die zweiten Kräfte eine Verkippung der Halbleiterbaugruppe (70, 80) bewirken können.

3. Schaltungsanordnung (1) nach Anspruch 1 oder 2, bei der die Federelemente (72, 82) am Rand der Halbleiterbaugruppe (70, 80) angeordnet sind.

4. Schaltungsanordnung (1) nach einem der vorangehenden Ansprüche mit einer Paste (60) zur Wärmeleitung und/oder elektrischen Leitung zwischen dem Deckelelement (50) und der dem Deckelelement (50) zugewandten Seite der Halbleiterbaugruppe (70, 80).

5. Schaltungsanordnung (1) nach einem der vorangehenden Ansprüche, bei der das Deckelelement (50) ein Kühlkörper (50) ist, insbesondere ein Kühlkörper (50) aus Kupfer.

6. Schaltungsanordnung (1) nach einem der Ansprüche 1 bis 4, bei der das Deckelelement (50) ein zweiter Schaltungsträger (30) ist.

7. Schaltungsanordnung (1) nach einem der vorangehenden Ansprüche, bei der das Material (100) bei Raumtemperatur flüssig ist.

8. Schaltungsanordnung (1) nach einem der Ansprüche 1 bis 6, bei der das Material (100) bei Raumtemperatur fest ist.

9. Schaltungsanordnung (1) nach einem der vorangehenden Ansprüche, bei der das Material (100) einen Gallium-Anteil aufweist.

10. Schaltungsanordnung (1) nach Anspruch 9, bei der das Material (100) eine eutektische Legierung mit Gallium, Indium und Zinn ist.
